# FASCICULE DE BREVET EUROPEEN

(11) **EP 3 520 110 B1**
(45) Date de publication et mention de la délivrance du brevet: **13.04.2022**
(21) Numéro de dépôt: 17783948.7
(22) Date de dépôt: 29.09.2017
(51) Int. Cl.: G11C 13/00, C04B 35/465, G11C 13/02, H01G 11/14, H01G 11/84, H01G 11/56, H01L 45/00, C04B 35/462

(54) **DISPOSITIF COMPRENANT UN SUPER-CONDENSATEUR ET PROCÉDÉ DE FABRICATION DE CE DISPOSITIF**
VORRICHTUNG BEINHALTEND EINEN SUPERKONDENSATOR UND VERFAHREN ZU IHRER HERSTELLUNG
DEVICE COMPRISING A SUPERCAPACITOR AND MANUFACTURING METHOD OF THE DEVICE

(30) Priorité: 29.09.2016 FR 1659322
(43) Date de publication de la demande: 07.08.2019
(73) Titulaire: Paris Sciences et Lettres, 75006 Paris (FR); Centre National de la Recherche Scientifique CNRS, 75016 Paris (FR); SORBONNE UNIVERSITE, 75006 Paris (FR); Ecole Supérieure de Physique et de Chimie Industrielles de la Ville de Paris, 75005 Paris (FR)
(72) Inventeur: LERIDON, Brigitte, 94230 Cachan (FR); HOLE, Stéphane, 75013 Paris (FR); FEDERICCI, Rémi, 78000 Versailles (FR)
(74) Mandataire: Plasseraud IP
(86) Numéro de dépôt international: PCT/FR2017/052678
(87) Numéro de publication internationale: WO 2018/060656

(56) Documents cités:
- EP-A1- 0 208 589
- EP-A1- 1 753 045
- EP-A1- 1 892 723
- EP-A1- 1 956 618
- EP-A1- 2 978 004
- US-A- 5 161 094
- US-A1- 2006 221 555

## Description

La présente invention concerne le domaine des composants électriques ou électroniques, de type condensateurs, notamment pour le stockage d'énergie ou d'information.

Elle concerne plus particulièrement un super-condensateur.

Intermédiaires entre les condensateurs fabriqués par dépôt électrolytique (dits « électrolytiques ») et les batteries rechargeables, les super-condensateurs possèdent l'avantage d'être plus rapides à la charge et à la décharge que les batteries et de permettre un stockage plus important que les condensateurs dits électrolytiques.

Leur densité d'énergie stockée reste toutefois trois à quatre fois plus faible que celle des batteries. Ils sont donc utilisés de manière complémentaire aux batteries.

Les super-condensateurs, ont par rapport aux condensateurs usuels une capacité environ 10000 fois plus élevée, typiquement de 150 Farad/g, d'où leur nom de « supercapacitor » ou « ultracapacitor » en anglais.

Les applications des super-condensateurs sont essentiellement pour le stockage temporaire d'énergie à bord notamment de véhicules, trains, bus, grues et ascenseurs. Ils permettent la récupération de l'énergie de freinage et un stockage de courte durée.

Les super-condensateurs servent aussi au stockage d'information dans des mémoires de type « Static random access memories » ou SRAM.

Parmi les super-condensateurs, on distingue les condensateurs à double couche où le stockage est purement électrostatique et les pseudo-condensateurs à stockage électrochimique. Il existe aussi des condensateurs hybrides qui mettent enjeu les deux effets.

Les super-condensateurs électrostatiques à double couche utilisent en général des électrodes de carbone ou de leurs dérivés et la séparation de charges se produit sur une très faible épaisseur (quelques Angströms) dans une double couche dite de Helmoltz à l'interface avec l'électrode. En dehors de cette double couche, l'électrolyte conduit ioniquement le courant électrique et forme ainsi une sorte d'électrode virtuelle.

En général, le super-condensateur comporte un électrolyte qui contient une membrane de séparation et qui est relié à deux électrodes de chaque côté de la membrane. Sous l'effet d'un champ électrique appliqué entre les électrodes, il se crée à la surface de celles-ci des doubles couches de Helmoltz de polarités opposées. Les charges de l'électrolyte viennent se concentrer au niveau de l'électrode, ce qui permet d'avoir une distance entre les charges de l'électrode et les charges de l'électrolyte très réduite et donc une grande capacitance d'interface. L'électrolyte étant par ailleurs partiellement conducteur, la partie centrale de l'électrolyte n'intervient pas dans l'assemblage en série des capacités formées par les doubles couches au niveau des électrodes.

Ce phénomène donne lieu à une capacité purement électrostatique. De plus, pour certains matériaux, des ions peuvent être absorbés par les électrodes. Il se superpose alors de surcroît un courant Faradique donnant lieu à une pseudo-capacitance supplémentaire. Ce courant n'est pas de même nature que le courant Faradique des batteries dans lesquelles il existe une réaction chimique. Dans le cas des super-condensateurs, le courant Faradique est plutôt lié à un phénomène physique (adsorption, intercalation) avec transfert de charges vers l'électrode.

Les électrodes utilisées sont en général des électrodes de carbone (carbone poreux, nanotubes de carbone ou même graphène).

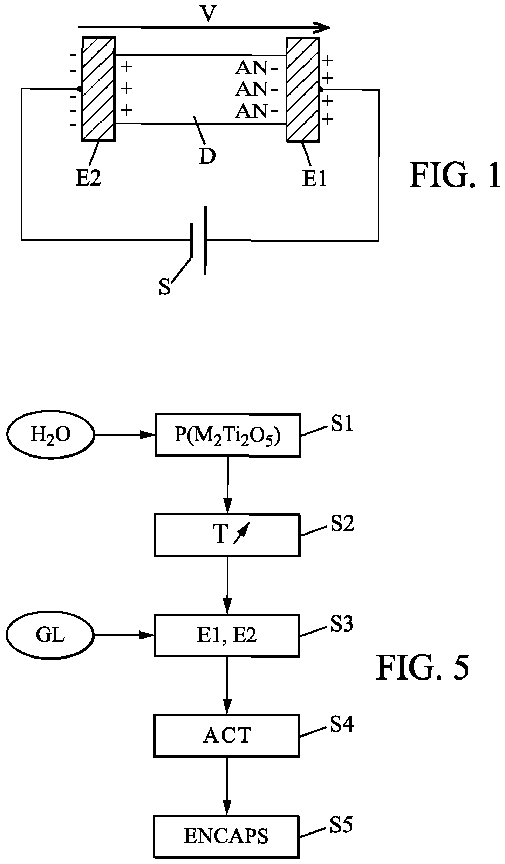

On a représenté à titre d'exemple illustratif sur la figure 1 une structure d'un tel super-condensateur. Cette structure comporte :
- l'électrolyte, réalisé dans un matériau D, et comportant une première extrémité et une deuxième extrémité opposée à la première extrémité,
- une première électrode E1 en contact avec la première extrémité de l'électrolyte D, et
- une deuxième électrode E2 en contact avec la deuxième extrémité de l'électrolyte D.

En particulier le matériau D est conducteur ionique. Ainsi, lorsqu'une tension V lui est appliquée (par exemple à l'aide d'une source S), il apparait une migration d'ions du matériau de l'électrolyte (par exemple des ions référencés AN- à titre d'exemple sur la figure 1) vers l'électrode de polarité opposée (l'électrode E1 chargée positivement dans l'exemple de la figure 1). Inversement, à l'autre électrode E2, le matériau se charge positivement, finalement à la manière d'un simple « macrodipôle ».

Des détails de fonctionnement de ce type de dispositif sont décrits notamment dans le document US-6,671,166.

Dans ce document notamment, le matériau de l'électrolyte est liquide, ce qui peut poser des problèmes de fabrication et de conditionnement des super-condensateurs comportant une telle solution électrolytique liquide, notamment pour des applications de fabrication de mémoires. De plus la capacitance obtenue, bien que très supérieure à celle des condensateurs classiques du fait de la faible épaisseur des doubles couches, reste limitée par la quantité totale de charges pouvant s'accumuler dans les doubles couches. EP 2 978 004 A1 divulgue un super-condensateur comportant deux électrodes et un électrolyte réalisé dans un matériau conducteur ionique, solide, inorganique et ayant une conductivité ionique supérieure à sa conductivité électronique.

La présente invention vient améliorer la situation.

Le dispositif comprenant au moins un super-condensateur selon l'invention est défini par les caractéristiques de la revendication 1. Le procédé de fabrication d'un dispositif à super-condensateur est défini par les caractéristiques de la revendication 14.

Ainsi, la présente invention vient vaincre un préjugé selon lequel l'utilisation d'un électrolyte solide inorganique ne permettrait pas de fabriquer un super-condensateur de performances satisfaisantes car ce super-condensateur est réputé être dominé par les pertes résistives. En réalité, il n'en est rien, comme présenté en détail ci-après, lorsque l'on dispose d'un conducteur ionique, isolant électronique, et possédant par conséquence une très forte constante diélectrique. En effet, les conducteurs ioniques précédemment envisagés pour les super-condensateurs, comme par exemple RbAg₄I₅ décrit dans :
*"Electrochemical Energy Storage for Renewable Sources and Grid Balancing",* édité par Patrick T. Moseley, Jürgen Garche (p. 374) ont des constantes diélectriques très faibles, de l'ordre de 10, ce qui n'est guère meilleur que les diélectriques des condensateurs classiques.

Toujours au sens de l'invention, le matériau choisi pour l'électrolyte est cristallin. On entend alors par « cristallin » un matériau monocristallin, ou encore résultant d'un agrégat de monocristaux, ou encore résultant d'un agrégat de grains cristallins (de taille nanométrique ou encore jusqu'à quelques centaines de microns, obtenu par exemple par frittage d'une poudre cristalline). Plus particulièrement, ce matériau cristallin comporte une structure cristallographique lamellaire présentant des plans atomiques parallèles entre eux, et entre lesquels des ions du matériau sont capables de se mouvoir, constituant ainsi la conductivité ionique du matériau.

On entend par « lamellaire » le fait que la structure présente un type de plan d'atomes perpendiculairement à une direction cristallographique, alors que ce type de plans n'est pas retrouvé dans le matériau perpendiculairement aux deux autres directions de l'espace. Cette structure lamellaire, dans des matériaux possibles pour l'électrolyte présentés plus loin, peut même présenter une structure mécanique en feuillets, voire exfoliable.

Il a été observé en effet que le déplacement ionique permettant d'accroître la densité de charge ionique en regard de l'électrode E1 dans l'exemple de la figure 1, pouvait concerner en particulier des ions présents à la surface des plans parallèles du matériau. Dans des exemples de matériaux à plans atomiques comportant de l'oxygène (de type AₓB₂O₅ présentés plus loin), il est apparu que ces ions mobiles sont des anions oxygène O²⁻.

Préférentiellement, les plans précités sont parallèles à une direction définie entre les première et deuxième extrémités (horizontaux, entre les première et deuxième électrodes, dans l'exemple de la figure 1).

Une famille de matériaux candidat présentant de tels plans d'atomes d'oxygène est du type A₂B₂O₅, avec :
- A comportant de l'hydrogène et/ou un alcalin (tel que du rubidium (Rb) et/ou du potassium (K)), et
- B comportant du Titane (Ti) ou un mélange de titane et d'une autre espèce atomique telle que du Niobium (Nb) (par exemple un mélange de 95% de Ti et 5% de Nb).

Comme présenté ci-après, un tel matériau offre des résultats inattendus en termes de constante diélectrique notamment, avec une conductivité électronique relativement faible, ce qui permet des applications avantageuses notamment au stockage de données en mémoire, ou encore au stockage d'énergie dans une utilisation du dispositif en tant que super-condensateur voire de pseudo-batterie comme il est montré plus loin.

Alternativement, des bronzes de vanadium peuvent être aussi envisagés.

Préférentiellement, les plans précités comportent des lacunes dans des sites d'oxygène. Une telle réalisation permet aux ions oxygène de se libérer plus facilement de leur site et de voyager dans l'espace entre les plans précités avant de combler une lacune ou de s'accumuler entre les plans précités pour migrer vers l'électrode E1. Cela permet également aux autres ions présents dans l'espace entre les plans précités de voyager plus facilement vers l'électrode E1. De telles lacunes peuvent être obtenues notamment par un recuit thermique, ou plus généralement par une étape « d'activation » de l'électrolyte pour le rendre diélectrique (très fortement diélectrique par rapport aux matériaux de l'art antérieur, comme on le verra plus loin).

Par ailleurs, l'une au moins des électrodes (ou les deux électrodes) peut être en carbone, comme présenté ci-avant, ou encore en argent, en or ou en platine (afin de limiter une éventuelle oxydation de l'électrode E1 notamment par l'électrolyte). Les électrodes peuvent être collées sur le diélectrique avec de la laque d'argent ou de carbone.

Comme indiqué ci-avant, la migration ionique dans l'électrolyte semble concerner essentiellement (mais pas uniquement) des ions oxygène O²⁻. D'autres types d'ions, capturés pendant la phase de recuit, peuvent également participer à la migration ionique, notamment des ions hydrogène ou hydroxyde. Pour ne pas perturber cette propriété, il est préférable de protéger le matériau de l'électrolyte d'une hydratation non contrôlée et dans une forme de réalisation, le dispositif comporte préférentiellement en outre une encapsulation du matériau solide au moins (éventuellement des électrodes aussi), dans une cellule étanche à l'humidité au moins (éventuellement à l'air plus généralement).

Notamment dans le cas d'un matériau d'électrolyte à plans atomiques d'oxygène, il apparait que le rapprochement des plans entre eux ou leur écartement mutuel favorise ou bloque au contraire la migration de charges dans l'électrolyte. Pour parvenir à ce résultat, il peut être appliqué une contrainte/relaxation des plans par application d'une force mécanique, ou encore par modification de la température, ou autre moyen.

Ainsi, dans un mode de réalisation, le dispositif comporte en outre au moins un actionneur mécanique en contact avec le matériau conducteur ionique solide, et une unité de commande pour piloter l'actionneur par application d'un signal de commande, et produire :
- une première force appliquée dans une ou plusieurs directions du matériau conducteur ionique solide, correspondant à un état de blocage des charges électriques dans l'électrolyte, et
- une deuxième force appliquée dans une ou plusieurs directions du matériau conducteur ionique solide, correspondant à un état de déblocage des charges électriques depuis l'électrolyte, une différence de la première force moins la deuxième force correspondant à une contrainte des plans atomiques.

Par exemple et de manière non limitative, cette force peut être appliquée perpendiculairement aux plans du matériau, ou encore de manière hydrostatique sur toutes les faces du matériau.

Par exemple, l'actionneur mécanique peut comporter un composant piézoélectrique en contact avec le matériau conducteur ionique solide, et l'unité de commande est alors configurée pour piloter le composant piézoélectrique par application d'un signal électrique.

Une telle réalisation peut être utile par exemple dans le cas d'usage où le super-condensateur est mis en œuvre dans une batterie de stockage électrique, avec :
- un état débloqué pendant les phases de charge de la batterie (phases de freinage par exemple d'un véhicule électrique ou hybride) et pendant les phases de décharge de la batterie (récupération d'énergie électrique stockée dans la batterie), et
- un état bloqué pendant une phase de non utilisation de la batterie (pendant que le véhicule est à l'arrêt et hors contact par exemple).

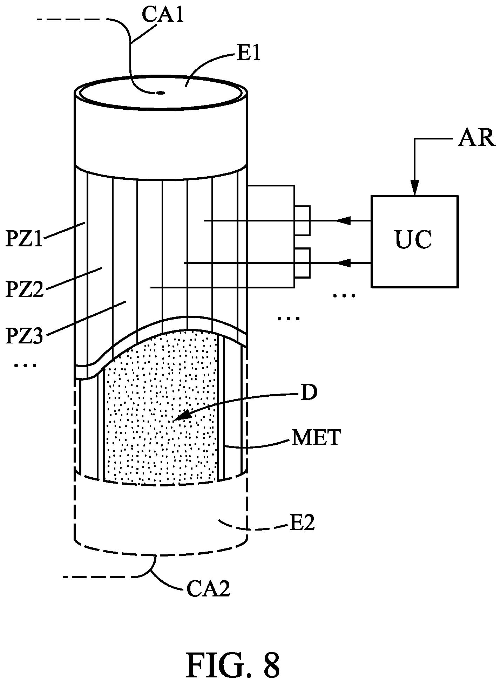

Un exemple d'une telle application est décrit plus loin en référence à la figure 8.

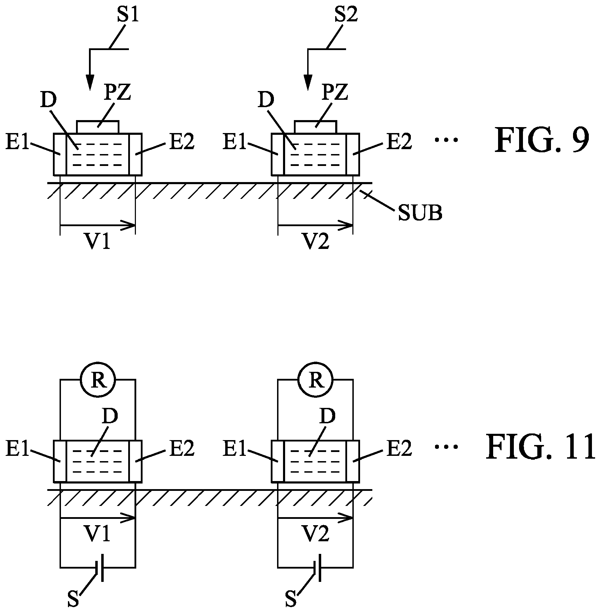

Alternativement, une telle réalisation peut être utile par exemple dans le cas d'usage où le super-condensateur est mis en œuvre dans une mémoire de stockage de données, notamment binaires, avec la possibilité de charger ou décharger chaque électrolyte d'un ensemble de super-condensateurs, puis de bloquer le matériau des électrolytes (avec une force mécanique locale, appliquée par des micropiézoélectriques respectifs) pour maintenir les états de charge respectifs. Un tel agencement permet donc un mode «écriture» de la mémoire. En mode lecture, il convient ensuite d'appliquer une deuxième force mécanique, différente, pour débloquer le matériau et le laisser décharger sa charge (ou sa « non-charge »). Ainsi, la lecture des courants de décharge permet de lire la mémoire. On peut ensuite appliquer à nouveau les mêmes charges que précédemment. Un exemple d'une telle application est décrit plus loin en référence à la figure 9.

En complément ou en variante d'une force mécanique appliquée, comme indiqué précédemment, une élévation/diminution de température peut être prévue. Ainsi, le dispositif de l'invention peut comporter en outre au moins un élément d'ajustement en température du matériau conducteur ionique solide, et une unité de commande pour piloter l'élément d'ajustement en température par application d'un signal de commande, et :
- amener la température du matériau conducteur ionique solide à une première température, pour maintenir le matériau conducteur ionique solide dans un état de blocage de charge électrique dans l'électrolyte, ou
- amener la température du matériau conducteur ionique solide à une deuxième température, pour maintenir le matériau conducteur ionique solide dans un état de déblocage de charge électrique depuis l'électrolyte, la première température étant supérieure à la deuxième température.

L'élément d'ajustement de température peut être par exemple (mais non limitativement) une diode d'émission laser focalisée sur l'électrolyte ou encore une résistance chauffante en contact avec le matériau ou encore un module Peltier.

Selon les essais réalisés notamment sur un matériau de type A₂B₂O₅ défini ci-avant, la première température est par exemple de l'ordre de ou supérieure à 60°C et la deuxième température est de l'ordre de la température ambiante, typiquement 20°C. On notera que le blocage thermique a également un avantage en termes de sécurité par rapport aux batteries classiques dont le risque d'explosion par emballement thermique est connu, puisque toute augmentation anormale de la température du matériau coupe automatiquement la délivrance d'un courant et met immédiatement fin à l'emballement thermique.

Dans l'application du dispositif où il est configuré en tant que batterie (pour stocker ou décharger une charge électrique dans ou respectivement depuis l'électrolyte), il est avantageux que le matériau conducteur ionique solide comporte des microcristaux (notamment pour piéger les charges en joints de grains et multiplier ainsi les charges stockées).

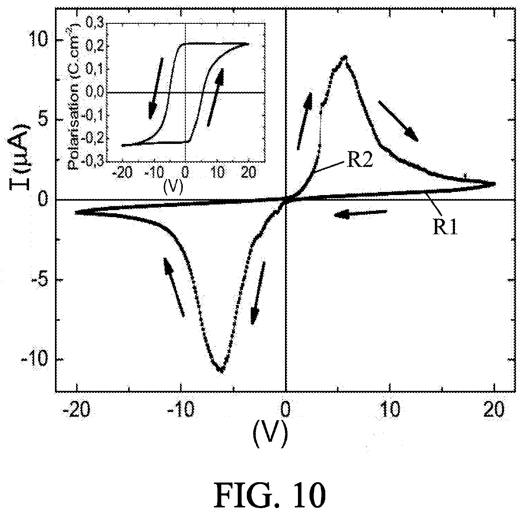

Une des propriétés du matériau de l'électrolyte, notamment dans le cas d'un matériau à plans atomiques d'oxygène (tel que par exemple de type A₂B₂O₅ défini ci-avant), et résultante des propriétés de blocage/déblocage des ions dans le matériau, est que le matériau présente une résistivité variable en fonction d'un signal électrique qui lui a été précédemment appliqué. Cette caractéristique est visible sur la figure 10, avec une forme d'hystérésis de la résistance du matériau (la pente des droites V(I)) en fonction de la tension (ou plus généralement d'un signal électrique) qui lui est appliquée. Ainsi, cette propriété ouvre la voie d'une application directe d'un tel super-condensateur au stockage de données en mémoire. Une telle réalisation est décrite plus loin en référence à la figure 11.

Dans une telle application, le dispositif est donc configuré pour stocker des données en tant que mémoire, selon :
- un mode d'écriture dans lequel une valeur de signal, choisie parmi au moins deux valeurs, est appliquée à l'électrolyte, et
- un mode de lecture dans lequel une résistance électrique de l'électrolyte est mesurée pour déterminer la valeur de signal précédemment appliquée en mode d'écriture.

Comme indiqué ci-avant, il convient « d'activer » le matériau de l'électrolyte pour lui conférer les propriétés précédemment décrites, et notamment sa possibilité de migration ionique. La présente invention vise alors en outre un procédé de fabrication d'un dispositif à super-condensateur tel que défini ci-avant, et comportant en particulier cette étape d'activation du matériau de l'électrolyte.

Dans une première forme de réalisation, l'étape d'activation peut comporter un recuit thermique, préférentiellement en atmosphère inerte (sous vide ou sous atmosphère d'un gaz neutre de type Hélium, Argon, ou Azote) à une température de l'ordre de 400°K.

En complément ou en variante, l'étape d'activation peut comporter un trempage du matériau solide dans de l'eau. Il a été observé aussi que ce simple procédé permettait effectivement d'activer le matériau.

En complément ou en variante, l'étape d'activation peut comporter l'application d'une forte tension, par exemple supérieure à 5 kV/m et préférentiellement de l'ordre de 10 kV/m par exemple.

D'autres avantages et caractéristiques de l'invention apparaîtront à la lecture de la description détaillée ci-après d'exemples de réalisation et à l'examen des dessins annexés sur lesquels :
- la figure 1 montre une structure d'un dispositif à super-condensateur comme présenté ci-dessus,
- la figure 2 montre la structure cristallographique d'un matériau convenant à titre d'exemple pour l'électrolyte d'un dispositif selon l'invention,
- la figure 3 illustre le module de la permittivité complexe (à partie réelle et partie imaginaire) à très basse fréquence (ici 0,01 Hz), correspondant en pratique à la constante diélectrique du matériau d'électrolyte, et ce en fonction de la température (en abscisse),
- la figure 4 montre la densité de polarisation du matériau d'électrolyte en fonction de la fréquence d'un signal électrique appliqué, à température ambiante,
- la figure 5 illustre schématiquement les étapes d'un procédé de fabrication d'un dispositif selon un mode de réalisation de l'invention,
- la figure 6 représente le courant spontané émis par un échantillon du matériau d'électrolyte de la figure 2, en fonction de la température appliquée, l'échantillon étant ici d'épaisseur de 1 mm et de section 4.10⁻⁸ m², et ayant été préalablement activé et chargé, la figure 6 illustrant ainsi le mécanisme de « blocage » de charge par la température,
- la figure 7 illustre la relaxation instantanée du courant après une charge pendant 30 minutes du matériau d'électrolyte, mesurée sur l'échantillon précité,
- la figure 8 illustre schématiquement un dispositif au sens de l'invention, dans une application en tant que batterie,
- la figure 9 illustre schématiquement un dispositif au sens de l'invention, dans une application en tant que mémoire à piézoélectriques PZ,
- la figure 10 montre la variation de la résistivité du matériau d'électrolyte en fonction d'une tension qui lui a été appliquée précédemment,
- la figure 11 illustre schématiquement un dispositif au sens de l'invention, dans une application en tant que mémoire basée sur le principe illustré sur la figure 10.

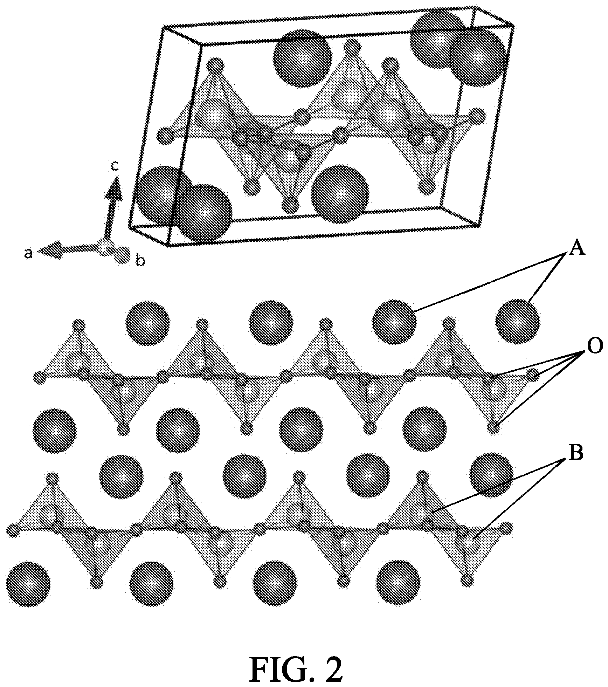

Comme indiqué précédemment, le matériau D de l'électrolyte du super-condensateur illustré sur la figure 1 est de type conducteur ionique et isolant électronique, solide. Un matériau de ce type et présentant en particulier des plans atomiques d'oxygène propices à une migration d'ions est illustré sur la figure 2 à titre d'exemple. Dans l'exemple représenté, il s'agit d'un cristal de formule chimique M₂Ti₂O₅, où M est hydrogène et/ou un alcalin comme par exemple, Rb, K, Cs, etc. La structure cristallographique de la figure 2 est C2/m. Ainsi, le Titane a ici une coordinence de 5 (contrairement à une pérovskite stoechiométrique où il aurait la coordinence 6). Un tel matériau présente avantageusement une structure lamellaire (plus particulièrement dans cet exemple de réalisation, de titanates lamellaires) avec des plans (Ti₂O₅)²⁻ séparés par des ions M⁺.

Dans les présentations d'exemples ci-après, le matériau de l'électrolyte est plus particulièrement du Rb₂Ti₂O₅, mais des propriétés similaires ont été observées aussi pour K₂Ti₂O₅ notamment. La structure du composé en plans atomiques d'oxygène lié à une autre espèce (ici du titane) séparés par un atome d'une autre espèce encore (hydrogène, ou un alcalin, ou autre) a apporté une contribution aux propriétés exposées ci-après. Une alternative à ce matériau est plus généralement de type M₂Ti₂C₅, où C est plutôt du Soufre (S) ou comporte un mélange de soufre et d'oxygène. Un autre matériau alternatif à plans parallèles entre lesquels peuvent circuler des ions est de la famille des bronzes de vanadium de formule MₓV₂O₅ où M est un composé parmi Al, Li, Zn, Ni, Na, Ag, H₃O, K, Ba ou Cs. Ces matériaux peuvent avoir des propriétés ioniques et électroniques intéressantes dans le cadre de l'invention.

Il a été observé sur le Rb₂Ti₂O₅ en particulier que ce matériau admet une constante diélectrique au-delà de toute attente (de l'ordre de 10⁸ pour la constante diélectrique relative) à basse fréquence (0,01 Hz) et entre -80°C et 80°C environ. Ici, la fréquence est relative à une éventuelle tension alternative appliquée à l'électrolyte, et il a été observé que la constante diélectrique décroit avec la fréquence. En effet, à basse fréquence cette constante diélectrique est associée à des mouvements ioniques (probablement d'ions oxygènes, comme montré plus loin) qui se déplacent soit sous l'effet d'un champ électrique, soit sous l'effet de la diffusion dans le matériau. La conductivité ionique est de l'ordre de 10⁻⁴ à 10⁻³ S.cm⁻¹. Ces ions ont la possibilité de venir s'accumuler aux extrémités de l'électrolyte comme illustré sur la figure 1 sous l'effet d'un champ électrique appliqué. Ils créent alors un macrodipôle qui confère des propriétés ferroélectriques au matériau avec une polarisation bien supérieure à celle des matériaux électrolytiques habituels, de l'ordre de 0.1 C.cm⁻². À titre de comparaison, il faudrait un champ électrique de 50 GV/mm dans le polyéthylène (polymère utilisé habituellement comme matériau diélectrique) pour atteindre la même polarisation, soit plus de 300 000 fois le champ de rupture du polyéthylène. Encore à titre de comparaison, en prenant une constante diélectrique équivalente de 10⁸, la densité d'énergie emmagasinée dans le matériau est de 568 J/cm³, soit de 160 mAh/cm³ ce qui est bien supérieur aux densités d'énergie emmagasinées dans les super-condensateurs classiques.

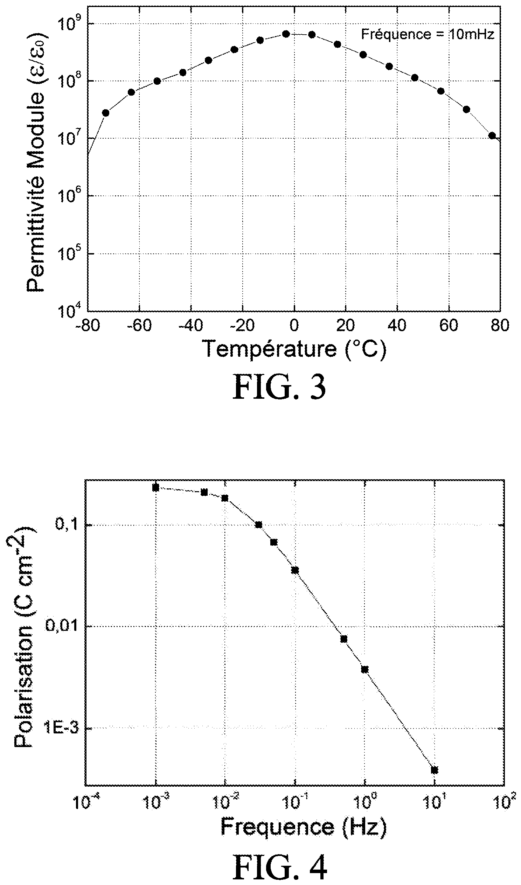

A l'extérieur de cette gamme de température, la constante diélectrique est très faible, comme illustré sur la figure 3. Ce matériau constitue donc un candidat de choix pour des applications autour de la température ambiante, entre -80 et +80°C. Pour d'autres applications (spatiales ou autre), un autre matériau de constitution similaire mais de formule différente peut être aussi envisagé. Par ailleurs, la figure 4 montre les performances du matériau en fonction de la fréquence de l'excitation électrique. Il apparait que ce matériau est avantageux pour opérer en particulier en tensions ou courants continus (en DC), ce qui est parfaitement compatible avec des applications de stockage de données en mémoire ou de stockage d'énergie électrique en batterie.

Lorsque les ions sont accumulés à une extrémité et que le champ électrique de polarisation est coupé, un courant de signe contraire à la tension appliquée est délivré dans un circuit extérieur récupérant ainsi l'énergie électrique (sous forme de courant et/ou de tension). Bien que la mobilité des ions dans le matériau à température ambiante soit relativement élevée, de l'ordre de 10⁻⁶ cm².s⁻¹.V⁻¹, la constante de diffusion reste assez faible (de l'ordre de 10⁻¹⁴ cm².s⁻¹) et la conductivité électronique interne est complètement négligeable. Ainsi les électrons ne peuvent pas écranter l'accumulation des ions et la polarisation très importante que ces ions produisent est entièrement disponible. Le courant récupéré de l'électrolyte dans le circuit extérieur précité est essentiellement de type « courant de déplacement » avec possiblement aussi une composante faradique de ce courant. L'observation d'une très forte polarisation du matériau laisse supposer que le transfert de charges à l'interface est négligeable.

Il est alors possible de réaliser un super-condensateur à base d'un matériau conducteur ionique et isolant électronique, solide, par exemple du type représenté sur la figure 2, tel que M₂Ti₂O₅, en utilisant le mouvement ionique au sein du matériau. A cet effet, on peut prévoir d'utiliser directement des cristaux ou des monocristaux, ou encore des frittages de nano-cristaux ou de microcristaux appropriés à base de ces matériaux et de les placer entre deux électrodes conductrices.

Le matériau présent dans le dispositif peut donc être de forme monocristalline, ou polycristalline. Dans la forme monocristalline, les électrodes peuvent simplement être mises en contact avec un monocristal de M₂Ti₂O₅ en utilisant de la laque d'argent ou de la colle carbone.

En référence à la figure 5, illustrant le procédé de fabrication d'un super-condensateur à base de poly-cristal, une quantité donnée d'eau est ajoutée à l'étape S1 à un ensemble de cristaux ou de microcristaux de M₂Ti₂O₅ sous forme de poudre. A l'étape S2, le mélange peut être compressé sous une forme de pastille. Par exemple, l'étape S2 peut consister à placer le mélange dans un four à 400° K pendant 20 minutes pour solidifier l'ensemble par évaporation de l'eau. Puis, dans un exemple de réalisation, à l'étape S3, des électrodes sont mises en contact avec cette pastille en utilisant une colle de type laque d'argent ou colle carbone. Alternativement, le mélange aqueux peut être encapsulé entre les deux électrodes et le tout peut être compressé dans un four de recuit. En outre, il est aussi possible de s'affranchir de la colle et/ou de la laque en exerçant une contrainte mécanique afin d'assurer un contact entre le matériau et les électrodes.

Les électrodes peuvent être réalisées en carbone, ou en cuivre, en or, en argent, en platine par exemple. Par ailleurs, une électrode peut être réalisée en outre dans un matériau différent de l'autre, pour des besoins d'une application spécifique.

Ensuite, une étape S4 « d'activation » du matériau de l'électrolyte pour le rendre conducteur ionique est mise en œuvre. En effet, avant toute utilisation, il convient d'« activer le matériau » selon l'une au moins et/ou l'autre des étapes ci-après :
- en recuisant le matériau sous atmosphère pauvre en oxygène pendant plusieurs heures,
- en lui appliquant de forts champs électriques (typiquement de l'ordre de 10 kV/m ou plus) pendant plusieurs heures à température ambiante,
- en l'hydratant avec une certaine quantité d'eau.

L'étape d'hydratation peut être avantageuse à mettre en œuvre dans le cas d'une poudre de microcristaux à fritter car elle permet à la fois d'activer le matériau et de fabriquer l'électrolyte. On peut donc ensuite recuire le mélange dans un four sous atmosphère ambiante à 400° K comme exposé ci-avant.

A l'étape S5, des matériaux du type représenté sur la figure 2 étant fortement hygroscopiques, il est prévu de maintenir l'électrolyte autant que possible sous atmosphère anhydre, et à cet effet de le protéger notamment de l'humidité par une encapsulation étanche, afin de ne pas altérer ses propriétés.

En outre, il a été observé parmi les propriétés du matériau (notamment M₂Ti₂O₅) la possibilité de récupérer un courant spontané de signe contraire à la tension de charge appliquée, et ce :
- immédiatement après une coupure de la tension (dans des conditions « normales » d'usage), ou
- après un délai qui suit la coupure de la tension, dans des conditions « particulières » pendant lequel est réalisé un blocage des ions à l'intérieur du matériau, en les empêchant de relaxer.

Au moins deux techniques de « blocage » des charges à l'intérieur du matériau peuvent être mises en œuvre.

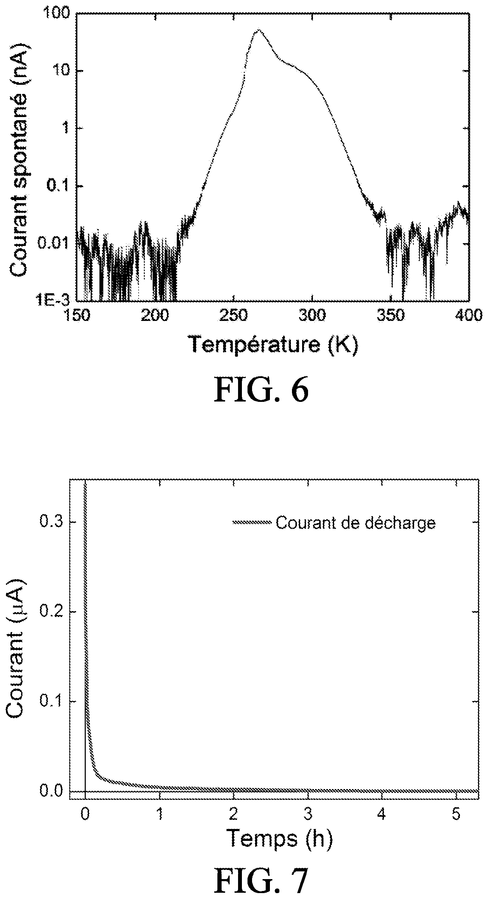

Dans un premier mode de réalisation, on élève localement la température dans le matériau de quelques dizaines de degrés (par exemple jusqu'à 60°C). On observe alors que le courant spontané cesse, comme illustré sur la figure 6. Le courant se rétablit spontanément lorsque la température revient à la température ambiante sans nécessiter d'autre processus de charge. L'élévation locale de température peut être produite par divers moyens, par exemple par chauffage laser, radiofréquence, résistif ou module Peltier.

Dans un deuxième mode de réalisation, alternatif ou en combinaison, il est possible de faire varier de manière appropriée la contrainte de pression que subit le matériau, afin de « bloquer » la décharge et maintenir la charge dans l'électrolyte, par application d'une force mécanique. Ensuite, l'application d'une force différente (par exemple une force « nulle » avec un relâchement de contrainte) permet de libérer la charge hors de l'électrolyte et récupérer ainsi le courant qui y était emmagasiné. La contrainte mécanique peut être réalisée par des systèmes mécaniques, piézoélectriques, électrostrictifs, magnétostrictifs ou magnéto-mécaniques par exemple.

Les super-condensateurs à base d'un matériau solide à conduction ionique, notamment de type M₂Ti₂O₅, présentent des densités de stockage de charges supérieures aux performances des dispositifs super-condensateurs existants en raison de la très forte constante diélectrique et donc de la très forte polarisation induite dans le matériau (typiquement 0.1 C/cm²), et ce pour une faible conduction électronique.

A moins de « bloquer » les charges du matériau de l'électrolyte, le temps de décharge est d'abord relativement rapide, de l'ordre de quelques minutes, puis relativement lent par la suite, de l'ordre de quelques heures, comme le montre la figure 7. Une application avantageuse consiste à prévoir un tel super-condensateur en tant que batterie, comme présenté ci-après en référence à la figure 8.

Sur la figure 8, le matériau D de l'électrolyte est préférentiellement sous forme polycristalline pour accumuler les charges dans les joints de grains, pendant les phases de charge. Le matériau D est en outre encapsulé dans une membrane étanche MET (anhydride) et des électrodes E1 et E2 lui sont accolées. Les électrodes E1 et E2 sont connectées à des câbles CA1, CA2, pour la charge et la décharge de la batterie. En outre, l'électrolyte est entouré d'une chemise d'éléments piézoélectriques PZ1, PZ2, PZ3... qui peuvent être commandés par un ou plusieurs signaux électriques émis par une unité de commande UC, afin d'appliquer au matériau D une force particulière permettant le blocage des charges dans l'électrolyte, durablement, par exemple après la réception au niveau de l'unité de commande UC d'un signal AR de mise à l'arrêt d'un véhicule automobile dans lequel cette batterie est implémentée.

On a représenté sur la figure 9 une autre application dans laquelle le dispositif de l'invention comporte plusieurs super-condensateurs agencés en série, chacun des super-condensateurs comportant :
- un électrolyte comprenant le matériau D conducteur ionique solide isolant électronique (par exemple sous la forme d'un monocristal du type représenté sur la figure 2, avec les plans atomiques d'oxygène horizontaux tels que représentés en traits pointillés sur la figure 9),
- deux électrodes E1 et E2 de part et d'autre du matériau D, pour adresser un signal V1, V2 de charge ou de « non-charge » de chaque super-condensateur, en mode écriture,
- un élément piézoélectrique PZ agencé pour appliquer une force mécanique variable sur l'électrolyte, et commandé par un signal électrique S1, S2, pour piloter un mode écriture ou un mode lecture de la mémoire.

Les super-condensateurs peuvent reposer sur un substrat SUB comportant des contacts appropriés pour connecter les électrodes E1 et E2. Dans un exemple de conception, d'une couche mince du matériau conducteur ionique solide D peut être déposée sur le substrat SUB, sur lequel des contacts ont été aménagés préalablement pour former les électrodes E1 et E2. Puis, par gravure, des éléments d'électrolyte sont isolés les uns des autres pour former un ensemble de super-condensateurs.

Ainsi, en mode écriture, un signal V1 de charge ou de « non-charge » peut être appliqué à un super-condensateur, puis l'élément piézoélectrique PZ est piloté par le signal S1 pour appliquer une force au matériau de l'électrolyte afin de le bloquer ensuite, avec la charge ou la « non-charge » qu'il a accumulé.

Ensuite, en mode lecture, un autre signal S2 est appliqué à l'élément piézoélectrique PZ (par exemple pour relâcher une contrainte qu'il (PZ) applique sur le matériau D de l'électrolyte). Dans ce cas, l'électrolyte se décharge, et un signal électrique correspondant peut être mesuré aux bornes des électrodes E1 et E2. En particulier, si une charge nulle est mesurée à cette étape, ce qui signifie alors simplement que l'électrolyte n'avait pas été chargé préalablement, une valeur binaire par exemple de 0 peut être associée, à une telle mesure. En revanche, si une charge au-delà d'un seuil est mesurée à cette étape, ce qui signifie alors que l'électrolyte avait été effectivement chargé préalablement, une valeur binaire par exemple de 1 peut être associée à cette mesure.

Il a été observé une autre propriété exploitable dans un matériau d'électrolyte conducteur ionique isolant électronique, solide, notamment du type représenté sur la figure 2. Il s'agit de la possibilité de mesurer par exemple une résistivité différente sur le matériau, en fonction d'une tension qui lui a été appliquée. Cette propriété, connue sous le nom de « memristivité », est illustrée par la figure 10, qui montre que des pentes V(I) du matériau (donc de sa résistance, ou plus généralement de sa résistivité) dépendent de la durée et de la valeur de la tension V qui lui a été précédemment appliquée. Une propriété équivalente est l'hystérésis de la polarisation du matériau en fonction de la tension V. De cette propriété découle une application, encore au stockage de données en mémoire, comme présenté ci-après en référence à la figure 11.

Dans ce mode de réalisation, les super-condensateurs sont reliés à des sources de tension S pour appliquer des tensions respectives V1, V2, pendant une durée respective t1, t2 de nature à « imprimer » une pente V(I) plus ou moins importante en fonction de la durée et de l'amplitude de la tension appliquée (typiquement correspondant à une forte valeur de résistance pour une faible tension V1 et/ou une faible durée t1, et au contraire à une faible valeur de résistance pour une tension V2 et/ou une durée t2 plus élevée, comme le montre la figure 11, pour des valeurs de tension positives). Un mode écriture en mémoire est ainsi défini. Pour le mode lecture, la résistance R de chaque super-condensateur peut être mesurée ensuite (en appliquant une tension de mesure plus petite que V 1 pour ne pas perturber la résistivité de l'électrolyte), cette mesure indiquant alors la valeur de tension V1 ou V2 précédemment appliquée au super-condensateur.

Bien entendu, alternativement, la polarisation peut être mesurée pour déterminer la tension précédemment appliquée.

De manière plus générale, la présente invention ne se limite pas aux formes de réalisation décrites ci-avant à titre d'exemple ; elle s'étend à d'autres variantes.

Ainsi, plus généralement, d'autres applications que celles présentées ci-dessus peuvent être envisagées.

Par ailleurs, on a décrit ici en référence un matériau de type de M₂Ti₂O₅ avec M alcalin (ou hydrogène). Néanmoins, d'autres matériaux candidats sont possibles, parmi ceux à plans atomiques d'oxygène, mais possiblement aussi parmi ceux à autre espèce atomique mobile agencée en plans, ou plus généralement encore tout type de matériau solide (autre que polymère et préférablement à forte conductivité ionique et faible conductivité électronique).

## Revendications

1. Dispositif comprenant au moins un super-condensateur comportant :
- un électrolyte comportant une première extrémité et une deuxième extrémité opposée à la première extrémité,
- une première électrode (E1) en contact avec la première extrémité de l'électrolyte, et
- une deuxième électrode (E2) en contact avec la deuxième extrémité de l'électrolyte, l'électrolyte est réalisé dans un matériau (D) conducteur ionique, solide. inorganique et ayant une conductivité ionique supérieure à sa conductivité électronique, lematériau solide est cristallin **caractérisé en ce que** le matériau comporte une structure cristallographique lamellaire formée de plans parallèles entre eux, de composition de type A₂B₂O₅ et entre lesquels des ions du matériau sont capables de se mouvoir, constituant ladite conductivité ionique du matériau.

2. Dispositif selon la revendication 1, **caractérisé en ce que** lesdits plans sont parallèles à une direction définie entre les première et deuxième extrémités.

3. Dispositif selon l'une des revendications précédentes, **caractérisé en ce que** l'élément A comporte de l'hydrogène.

4. Dispositif selon l'une des revendications précédentes, **caractérisé en ce que** l'élément A comporte un alcalin.

5. Dispositif selon la revendication 4, **caractérisé en ce que** l'alcalin comporte au moins un élément parmi du rubidium et du potassium.

6. Dispositif selon l'une des revendications précédentes, **caractérisé en ce que** l'élément B comporte du titane.

7. Dispositif selon la revendication 6, **caractérisé en ce que** l'élément B comporte un mélange de titane et de niobium.

8. Dispositif selon l'une des revendications précédentes, **caractérisé en ce que** lesdits plans comportent des lacunes dans des sites d'oxygène.

9. Dispositif selon l'une des revendications précédentes, **caractérisé en ce qu'**il comporte en outre une encapsulation du matériau solide au moins, dans une cellule étanche à l'humidité au moins.

10. Dispositif selon l'une des revendications précédentes, **caractérisé en ce qu'**il comporte en outre au moins un actionneur mécanique en contact avec le matériau conducteur ionique solide, et une unité de commande pour piloter l'actionneur par application d'un signal de commande, et produire :
- une première force appliquée au matériau conducteur ionique solide, correspondant à un état de blocage de charges électriques dans l'électrolyte, et
- une deuxième force appliquée au matériau conducteur ionique solide, correspondant à un état de déblocage de charges électriques depuis l'électrolyte, une différence de la première force moins la deuxième force correspondant à une contrainte des plans atomiques du matériau.

11. Dispositif selon la revendication 10, **caractérisé en ce que** l'actionneur mécanique comporte un composant piézoélectrique en contact avec le matériau conducteur ionique solide, et **en ce que** l'unité de commande est configurée pour piloter le composant piézoélectrique par application d'un signal électrique.

12. Dispositif selon l'une des revendications précédentes, **caractérisé en ce qu'**il comporte en outre au moins un élément d'ajustement en température du matériau conducteur ionique solide, et une unité de commande pour piloter l'élément d'ajustement en température par application d'un signal de commande, et :
- amener la température du matériau conducteur ionique solide à une première température, pour maintenir le matériau conducteur ionique solide dans un état de blocage de charge électrique dans l'électrolyte, ou
- amener la température du matériau conducteur ionique solide à une deuxième température, pour maintenir le matériau conducteur ionique solide dans un état de déblocage de charge électrique depuis l'électrolyte, la première température étant plus élevée que la deuxième température.

13. Dispositif selon l'une des revendications précédentes, **caractérisé en ce que** le matériau conducteur ionique solide présente une résistivité variable en fonction d'un signal électrique précédemment appliqué au matériau conducteur ionique solide,
et **en ce que** le dispositif est configuré pour stocker des données en tant que mémoire, selon:
- un mode d'écriture dans lequel une valeur de signal, choisie parmi au moins deux valeurs, est appliquée à l'électrolyte pendant au moins une durée déterminée, et
- un mode de lecture dans lequel une résistance électrique de l'électrolyte est mesurée pour déterminer la valeur de signal précédemment appliquée en mode d'écriture.

14. Procédé de fabrication d'un dispositif à super-condensateur selon l'une des revendications précédentes, **caractérisé en ce qu'**il comporte une étape d'activation du matériau de l'électrolyte.

15. Procédé selon la revendication 14, **caractérisé en ce que** l'étape d'activation comporte un recuit thermique en atmosphère inerte à une température de l'ordre de 400K.

16. Procédé selon l'une des revendications 14 et 15, **caractérisé en ce que** l'étape d'activation comporte un trempage du matériau solide dans de l'eau.

17. Procédé selon l'une des revendications 14 à 16, **caractérisé en ce que** l'étape d'activation comporte l'application d'une tension supérieure à 5 kV/m.

## Patentansprüche

1. Vorrichtung mit wenigstens einem Superkondensator, umfassend:
- einen Elektrolyten mit einem ersten Ende und einem zweiten Ende, das dem ersten Ende gegenüberliegt,
- eine erste Elektrode (E1), die mit dem ersten Ende des Elektrolyten in Kontakt steht, und
- eine zweite Elektrode (E2), die mit dem zweiten Ende des Elektrolyten in Kontakt steht,
wobei der Elektrolyt aus einem festen, anorganischen, ionenleitenden Material (D) besteht, dessen lonenleitfähigkeit größer ist als seine Elektronenleitfähigkeit und wobei das feste Material kristallin ist, **dadurch gekennzeichnet, dass** das Material eine lamellenartige kristallographische Struktur aufweist, die aus zueinander parallelen Ebenen mit einer Zusammensetzung vom Typ A₂B₂O₅ besteht, zwischen denen sich die Ionen des Materials bewegen können und die die lonenleitfähigkeit des Materials bilden.

2. Vorrichtung nach Anspruch 1, **dadurch gekennzeichnet, dass** die Ebenen parallel zu einer Richtung verlaufen, die zwischen dem ersten und dem zweiten Ende definiert ist.

3. Vorrichtung nach einem der vorhergehenden Ansprüche, **dadurch gekennzeichnet, dass** das Element A Wasserstoff enthält.

4. Vorrichtung nach einem der vorhergehenden Ansprüche, **dadurch gekennzeichnet, dass** das Element A ein Alkali enthält.

5. Vorrichtung nach Anspruch 4, **dadurch gekennzeichnet, dass** das Alkali wenigstens eines der Elemente Rubidium und Kalium enthält.

6. Vorrichtung nach einem der vorhergehenden Ansprüche, **dadurch gekennzeichnet, dass** das Element B Titan enthält.

7. Vorrichtung nach Anspruch 6, **dadurch gekennzeichnet, dass** das Element B eine Mischung aus Titan und Niob enthält.

8. Vorrichtung nach einem der vorhergehenden Ansprüche, **dadurch gekennzeichnet, dass** die Ebenen Lücken in Sauerstoffstellen aufweisen.

9. Vorrichtung nach einem der vorhergehenden Ansprüche, **dadurch gekennzeichnet, dass** diese ferner eine Einkapselung wenigstens des festen Materials in einer wenigstens feuchtigkeitsdichten Zelle umfasst.

10. Vorrichtung nach einem der vorhergehenden Ansprüche, **dadurch gekennzeichnet, dass** diese ferner wenigstens einen mechanischen Aktuator in Kontakt mit dem festen ionenleitenden Material und eine Steuereinheit zum Ansteuern des Aktuators durch Anlegen eines Steuersignals umfasst und zum Erzeugen:
- einer ersten Kraft, die auf das feste ionenleitende Material ausgeübt wird, die einem Zustand entspricht, in dem elektrische Ladungen im Elektrolyten blockiert sind, und
- einer zweiten Kraft, die auf das feste ionenleitende Material ausgeübt wird und einem Zustand entspricht, in dem elektrische Ladungen aus dem Elektrolyten freigegeben werden, wobei eine Differenz aus der ersten Kraft minus der zweiten Kraft einer Belastung der Atomebenen des Materials entspricht.

11. Vorrichtung nach Anspruch 10, **dadurch gekennzeichnet, dass** der mechanische Aktuator eine piezoelektrische Komponente umfasst, die mit dem festen ionenleitenden Material in Kontakt steht, und dass die Steuereinheit dazu ausgebildet ist, die piezoelektrische Komponente durch Anlegen eines elektrischen Signals anzutreiben.

12. Vorrichtung nach einem der vorhergehenden Ansprüche, **dadurch gekennzeichnet, dass** sie ferner wenigstens ein Element zur Temperatureinstellung des festen ionenleitenden Materials umfasst und eine Steuereinheit zum Ansteuern des Elements zur Temperatureinstellung durch Anlegen eines Steuersignals und:
- um die Temperatur des festen ionenleitenden Materials auf eine erste Temperatur zu bringen, um das feste ionenleitende Material in einem Zustand zu halten, in dem die elektrische Ladung im Elektrolyten blockiert ist, oder
- um die Temperatur des festen ionenleitenden Materials auf eine zweite Temperatur bringen, um das feste ionenleitende Material in einem Zustand zu halten, in dem die elektrische Ladung aus dem Elektrolyten freigegeben wird, wobei die erste Temperatur höher ist als die zweite Temperatur.

13. Vorrichtung nach einem der vorhergehenden Ansprüche, **dadurch gekennzeichnet, dass** das feste ionenleitende Material einen spezifischen Widerstand aufweist, der sich in Abhängigkeit von einem zuvor an das feste ionenleitende Material angelegten elektrischen Signal ändert,
und dadurch, dass die Vorrichtung dazu ausgebildet ist, Daten als Speicher zu speichern, gemäß:
- einem Schreibmodus, in dem ein Signalwert, der aus wenigstens zwei Werten ausgewählt ist, für wenigstens eine bestimmte Zeitdauer an den Elektrolyten angelegt wird, und
- einem Lesemodus, in dem ein elektrischer Widerstand des Elektrolyten gemessen wird, um den Signalwert zu bestimmen, der zuvor im Schreibmodus angelegt wurde.

14. Verfahren zur Herstellung einer Superkondensatorvorrichtung nach einem der vorhergehenden Ansprüche, **dadurch gekennzeichnet, dass** es einen Schritt der Aktivierung des Elektrolytmaterials umfasst.

15. Verfahren nach Anspruch 14, **dadurch gekennzeichnet, dass** der Aktivierungsschritt ein thermisches Glühen in einer inerten Atmosphäre bei einer Temperatur in der Größenordnung von 400 K umfasst.

16. Verfahren nach einem der Ansprüche 14 und 15, **dadurch gekennzeichnet, dass** der Aktivierungsschritt ein Einweichen des festen Materials in Wasser umfasst.

17. Verfahren nach einem der Ansprüche 14 bis 16, **dadurch gekennzeichnet, dass** der Aktivierungsschritt das Anlegen einer Spannung von mehr als 5 kV/m umfasst.

## Claims

1. Device comprising at least one supercapacitor comprising:
- an electrolyte having a first end and a second end opposite the first end,
- a first electrode (E1) in contact with the first end of the electrolyte, and
- a second electrode (E2) in contact with the second end of the electrolyte,
the electrolyte being made of a solid, inorganic, ion-conductive material (D) having an ionic conductivity that is greater than its electronic conductivity,
the solid material being crystalline, **characterized in that** the material comprises a lamellar crystallographic structure formed of planes parallel to each other, having a composition of the A₂B₂O₅ type, and between which ions of the material are able to move, constituting said ionic conductivity of the material.

2. Device according to claim 1, wherein said planes are parallel to a defined direction between the first and second ends.

3. Device according to anyone of the preceding claims, wherein element A comprises hydrogen.

4. Device according to anyone of the preceding claims, wherein element A comprises an alkali.

5. Device according to claim 4, wherein the alkali comprises at least one element among rubidium and potassium.

6. Device according to anyone of the preceding claims, wherein element B comprises titanium.

7. Device according to claim 6, wherein element B comprises a mixture of titanium and niobium.

8. Device according to anyone of the preceding claims, wherein said planes have vacancies in oxygen sites.

9. Device according to one of the preceding claims, wherein it further comprises encapsulation of at least the solid material, in a cell sealed at least against humidity.

10. Device according to anyone of the preceding claims, wherein it further comprises at least one mechanical actuator in contact with the solid ion-conductive material, and a control unit for controlling the actuator by applying a control signal, and producing:
- a first force applied to the solid ion-conductive material, corresponding to a state of locking the electric charges in the electrolyte, and
- a second force applied to the solid ion-conductive material, corresponding to a state of releasing the electric charges from the electrolyte, a difference of the first force minus the second force corresponding to a stressing of the atomic planes of the material.

11. Device according to claim 10, wherein the mechanical actuator comprises a piezoelectric component in contact with the solid ion-conductive material, and wherein the control unit is configured to control the piezoelectric component by application of an electrical signal.

12. Device according to one of the preceding claims, further comprising at least one member for adjusting the temperature of the solid ion-conductive material, and a control unit for controlling the temperature adjusting member by applying a control signal, and:
- bringing the temperature of the solid ion-conductive material to a first temperature, in order to maintain the solid ion-conductive material in a state of locking the electric charge in the electrolyte, or
- bringing the temperature of the solid ion-conductive material to a second temperature, in order to maintain the solid ion-conductive material in a state of releasing electric charge from the electrolyte, the first temperature being higher than the second temperature.

13. Device according to one of the preceding claims, wherein the solid ion-conductive material has variable resistivity as a function of an electrical signal previously applied to the solid ion-conductive material,
and wherein the device is configured as memory for storing data, with:
- a write mode in which a signal value, selected from at least two values, is applied to the electrolyte for at least a predetermined duration, and
- a read mode in which an electrical resistance of the electrolyte is measured in order to determine the signal value previously applied in write mode.

14. Method for fabricating a device with supercapacitor according to one of the preceding claims, **characterized in that** it comprises a step of activating the material of the electrolyte.

15. Method according to claim 14, wherein the activation step comprises thermal annealing in an inert atmosphere at a temperature of about 400K.

16. Method according to one of claims 14 and 15, wherein the activation step comprises soaking the solid material in water.

17. Method according to one of claims 14 to 16, wherein the activation step comprises the application of a voltage greater than 5 kV/m.
